# EUROPEAN PATENT APPLICATION

(11) **EP 4 757 510 A1**
(43) Date of publication of application: **10.06.2026**
(21) Application number: 25163120.6
(22) Date of filing: 11.03.2025
(51) Int. Cl.: H05K 5/03

(54) **TORSION-RESISTANT POWER BANK ENCLOSURE AND MOBILE POWER BANK**

(30) Priority: 09.12.2024 CN 202423033702 U
(71) Applicant: Sysmax Innovations Co., Ltd., Guangzhou 510520 (CN)
(72) Inventor: LI, Wenjie, Guangzhou, Guangdong, 510520 (CN)
(74) Representative: KIPA AB

(57) **Abstract**

A torsion-resistant power bank enclosure and a mobile power bank are provided. The torsion-resistant power bank enclosure includes: a plurality of torsion-resistant protrusions are respectively arranged on opposing bottom surfaces of the housing, and torsion-resistant assembly is respectively arranged on opposing side surfaces of the housing corresponding to edges of the bottom surfaces; cover panels, two cover panels are respectively embedded and fitted onto the two bottom surfaces and are interlocked with the torsion-resistant protrusions, and the torsion-resistant assembly is arranged to engage with corresponding edges of the cover panels; a sealing member is arranged to fit over and interlock with one end of the housing. The present application achieves the function by providing a plurality of torsion-resistant protrusions that interlock with cover panels and by arranging a torsion-resistant assembly on the housing to interlock with the cover panels. When the power bank enclosure is subjected to torsional forces, during the deformation process of the housing, the cover panels pull on the plurality of torsion-resistant protrusions to limit the extent of deformation. Simultaneously, the torsion-resistant assembly restricts the position of the cover panels to further reduce deformation. The configuration prevents damage to internal components due to excessive deformation of the housing and minimizes safety risks that may arise from accidental situations during the use of the power bank.

## Description

### FIELD

The present application relates to the technology field of power bank protection, and in particular to a torsion-resistant power bank enclosure and a mobile power bank.

### BACKGROUND

A power bank, also known as a mobile power bank, is a personal, portable device capable of storing electrical energy and primarily used to charge handheld mobile devices and other consumer electronics. The main components include: a battery for energy storage, a circuit to stable output the voltage, and most mobile power banks are arranged with a charger to recharge an internal battery.

The primary application of power banks is in outdoor settings where there is no power supply, which means that the power bank is likely to be affected by unexpected situations during use. In prior art, the enclosure of a power bank typically includes a form-fitting enclosure that matches the shape of the internal battery, such as the enclosure disclosed in CN113675928A. While the type of enclosure can provide protection against bumps and impacts, when subjected to external torsional forces, the enclosure is prone to deformation, which can lead to damage to internal components, failing to offer adequate protection and posing certain safety risks.

Therefore, the prior art requires further improvement and development.

### SUMMARY

To solve the limitations in prior art, where power bank enclosures typically use form-fitting enclosures that match shape of internal battery, providing protection against bumps and impacts, but being prone to deformation under external torsional forces, which can lead to damage to internal components and pose safety risks, the present application provides a torsion-resistant power bank enclosure and a mobile power bank.

The objectives of the present application are achieved through the following technical solutions:

A torsion-resistant power bank enclosure includes:
a housing, a plurality of torsion-resistant protrusions are respectively arranged on opposing bottom surfaces of the housing, and a torsion-resistant assembly is respectively arranged on opposing side surfaces of the housing corresponding to edges of the bottom surfaces;
cover panels, two cover panels are respectively embedded and fitted onto the two bottom surfaces and interlocked with the torsion-resistant protrusions, and the torsion-resistant assembly is arranged to engage with corresponding edges of the cover panels;
a sealing member, the sealing member is arranged to fit over and interlock with one end of the housing.

**In** the torsion-resistant power bank enclosure, the torsion-resistant assembly is fixedly arranged on the housing;
the torsion-resistant assembly extends toward the bottom surfaces, and side edges of the torsion-resistant assembly is bent toward the cover panels to form a first mounting groove, the edges of the cover panels are engaged within the first mounting groove.

In the torsion-resistant power bank enclosure, the torsion-resistant assembly is removably arranged on the housing;
the torsion-resistant assembly includes a first clip plate and a second clip plate arranged at a predetermined distance opposite to each other, and a connecting plate fixedly connected to one end of both the first clip plate and the second clip plate; side edges of both the first clip plate and the second clip plate are bent toward the cover panels to form a second mounting groove, and the edges of the cover panels and the housing are engaged within the second mounting groove.

In the torsion-resistant power bank enclosure, another end of the housing is closed;
a plurality of mounting holes are arranged at the one end of the housing corresponding to the sealing member;
the sealing member is arranged with elastic snap fasteners compatible with the mounting holes; and/or the sealing member is arranged with screws compatible with the mounting holes.

In the torsion-resistant power bank enclosure, a plurality of positioning holes are arranged through the cover panels, positions of the plurality of positioning holes are corresponding to positions of the plurality of torsion-resistant protrusions, and the torsion-resistant protrusions are set through and fitted into the positioning holes.

In the torsion-resistant power bank enclosure, the bottom surfaces of the housing are hollowed out at a center, and the torsion-resistant protrusions are uniformly arranged along the edges of the bottom surfaces.

In the torsion-resistant power bank enclosure, the cover panels are carbon fiber cover panels.

In the torsion-resistant power bank enclosure, a plurality of connecting ribs are arranged inside the housing, and two ends of each connecting rib are respectively fixedly connected to the two bottom surfaces.

In the torsion-resistant power bank enclosure, a plurality of guiding ribs are arranged inside the housing, one end of each guiding rib is inclined, and the plurality of guiding ribs are arranged to position and mount functional components inside the housing.

A mobile power bank, the mobile power bank includes the torsion-resistant power bank enclosure.

The beneficial effects of the present application are in the following: the present application achieves the function by providing a plurality of torsion-resistant protrusions that interlock with cover panels and by arranging a torsion-resistant assembly on the housing to interlock with the cover panels. When the power bank enclosure is subjected to torsional forces, during the deformation process of the housing, the cover panels pull on the plurality of torsion-resistant protrusions to limit the extent of deformation. Simultaneously, the torsion-resistant assembly restricts the position of the cover panels to further reduce deformation. The configuration prevents damage to internal components due to excessive deformation of the housing and minimizes safety risks that may arise from accidental situations during the use of the power bank.

### BRIEF DESCRIPTION OF THE DRAWINGS

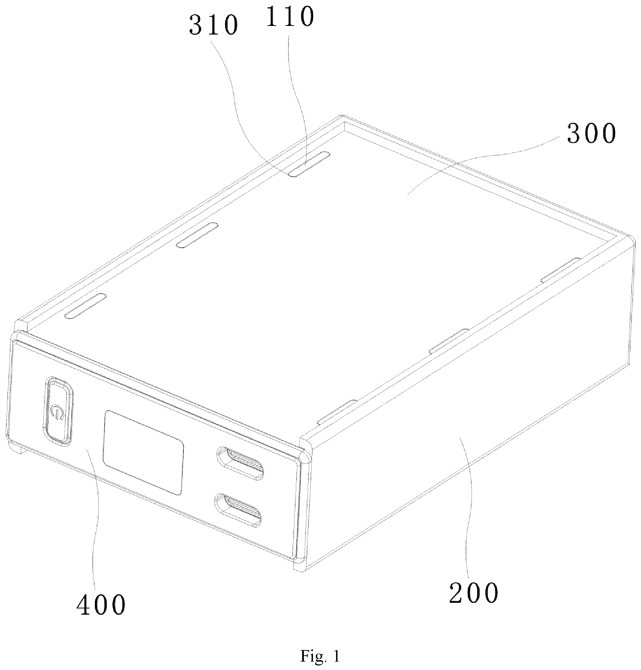

Fig. 1 is a perspective view of a torsion-resistant power bank enclosure of the present application;
Fig. 2 is an exploded view of cover panels removed from the torsion-resistant power bank enclosure of the present application;
Fig. 3 is an exploded view of a first embodiment of the torsion-resistant power bank enclosure of the present application;
Fig. 4 is an exploded view of a second embodiment of the torsion-resistant power bank enclosure of the present application;
Fig. 5 is a first schematic diagram showing the torsional resistance in the torsion-resistant power bank enclosure of the present application;
Fig. 6 is a second schematic diagram showing the torsional resistance in the torsion-resistant power bank enclosure of the present application.
From Fig. 1 to Fig. 6: 100-housing; 110-torsion-resistant protrusions; 120-mounting hole; 130-connecting rib; 140-guiding rib; 200-torsion-resistant assembly; 210-first mounting groove; 220-second mounting groove; 231-first clip plate; 232-second clip plate; 233-connecting plate; 300-cover panels; 310-positioning holes; 400-sealing member; 410-elastic snap fasteners; 420-screw.

### DETAILED DESCRIPTION OF EMBODIMENTS

To clarify the objectives, technical solutions, and effects of the present application, the following detailed description is provided with reference to the accompanying drawings and exemplary embodiments. It should be understood that the embodiments described herein are intended only for the purpose of explaining the present application and do not limit the scope of the present application.

It should be noted that any directional indicators (such as top, bottom, left, right, front, back, etc.) referenced in the embodiments of the present application are intended to explain the relative positional relationships and motion conditions of the components in a specific posture (as shown in the figures). When the specific posture changes, the directional indicators will also change correspondingly to reflect the new relative positions and orientations.

Additionally, any descriptions using terms such as "first", "second", etc., in the embodiments of the present application are used solely for descriptive purposes and should not be construed as indicating or implying relative importance or specifying the quantity of the technical features indicated. Therefore, features described with "first", "second", etc., explicitly or implicitly include at least one such feature. Furthermore, the technical solutions from different embodiments can be combined on the basis that such combinations can be implemented by those skilled in the art. If the combination of technical solutions results in contradictions or is unachievable, such combinations shall be considered non-existent and fall outside the scope of protection claimed by the present application.

The primary application of power banks is in outdoor settings where there is no power supply, which means that the power bank is likely to be affected by unexpected situations during use. In prior art, the enclosure of a power bank typically includes a form-fitting enclosure that matches the shape of the internal battery, such as the enclosure disclosed in CN113675928A. While the type of enclosure can provide protection against bumps and impacts, when subjected to external torsional forces, the enclosure is prone to deformation, which can lead to damage to internal components, failing to offer adequate protection and posing certain safety risks.

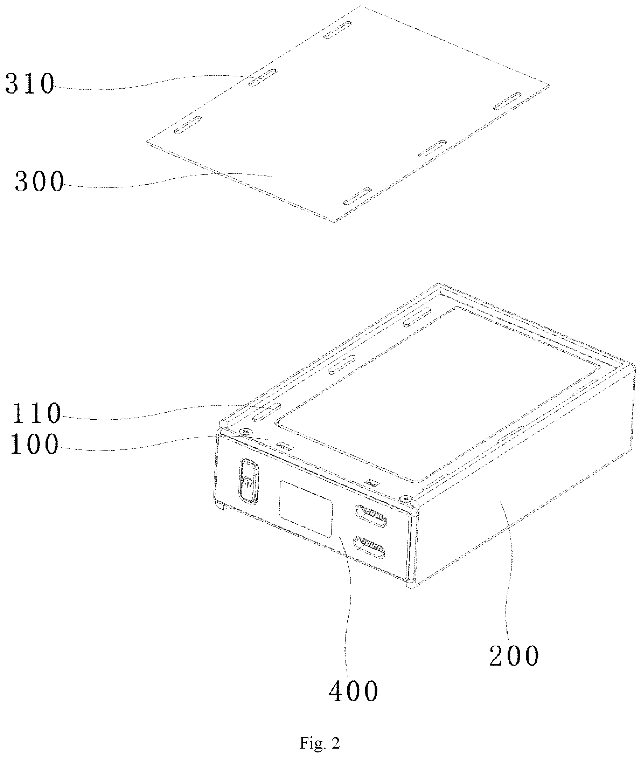

Based on the problems in the prior art, the present application provides a torsion-resistant power bank enclosure as shown in Fig. 1 and Fig. 2. The torsion-resistant power bank enclosure includes: a housing 100, a plurality of torsion-resistant protrusions 110 are respectively arranged on opposing bottom surfaces of the housing 100, and a torsion-resistant assembly 200 is respectively arranged on opposing side surfaces of the housing corresponding to edges of the bottom surfaces; cover panels 300, two cover panels 300 are respectively embedded and fitted onto the two bottom surfaces and interlock with the torsion-resistant protrusions 110; the torsion-resistant assembly 200 is arranged to engage with corresponding edges of the cover panels 300; and a sealing member 400, the sealing member 400 is arranged to fit over and interlock with one end of the housing 100.

The present application achieves the function by providing a plurality of torsion-resistant protrusions 110 that interlock with cover panels 300 and by arranging a torsion-resistant assembly 200 on the housing 100 to interlock with the cover panels 300. When the power bank enclosure is subjected to torsional forces, during the deformation process of the housing 100, the cover panels 300 pull on the plurality of torsion-resistant protrusions 110 to limit the extent of deformation. Simultaneously, the torsion-resistant assembly 200 restricts the position of the cover panels 300 to further reduce deformation. The configuration prevents damage to internal components due to excessive deformation of the housing 100 and minimizes safety risks that may arise from accidental situations during the use of the power bank.

In the embodiments and as shown in Fig. 1 and Fig. 2, the main structure of the torsion-resistant power bank enclosure includes a housing 100, cover panels 300, and a sealing member 400. The housing 100 is made of plastic or lightweight metal materials and is shaped as an approximate rectangular cuboid. For descriptive purposes, two largest-area sides of the housing 100 are designated as the bottom surfaces and the two bottom surfaces are same structure. Each bottom surface includes a plurality of torsion-resistant protrusions 110 that protrude outward from the housing 100. Moreover, on opposing side surfaces corresponding to the edges of the bottom surfaces, a torsion-resistant assembly 200 is arranged. The torsion-resistant assembly 200 is used to secure the cover panels 300.

The cover panels 300 have length and a width dimension that match the bottom surfaces and are embedded in the two bottom surfaces during actual mounting, interlocking with the torsion-resistant protrusions 110. In one aspect, a mounting of the cover panels 300 is positioned through the torsion-resistant protrusions 110, and in another aspect, when the housing 100 is subjected to torsional forces, a cooperation with the plurality of torsion-resistant protrusions 110 limits further deformation of the housing 100, thereby reducing the deformation of the power bank enclosure under torsional force and lowering the probability of damage to the functional components inside the housing 100; in the present embodiment, the side edges of the cover panels 300 are engaged by the torsion-resistant assembly 200 arranged on the housing 100, which in one aspect, increases the structural strength of the housing 100 by setting the torsion-resistant assembly 200, and in another aspect, locks the position of the cover panels 300 through the torsion-resistant assembly 200, thus exerting a reverse pulling effect when the housing 100 deforms.

The sealing member 400 is used to seal an opening of the housing 100. In a specific embodiment, the housing 100 of the power bank is typically arranged to be closed at one end to enhance the integrality of the housing 100. Therefore, after the functional components are installed inside the housing 100, the opening of the housing 100 is sealed through the sealing member 400, which not only ensures the structural stability of the assembled power bank but also allows for the mounting of necessary circuit structures through the sealing member 400, facilitating user operation and maintenance.

Based on the embodiments, the torsion-resistant assembly 200 of the torsion-resistant power bank enclosure in the present application can be arranged in multiple ways to meet structural requirements of different models of power banks.

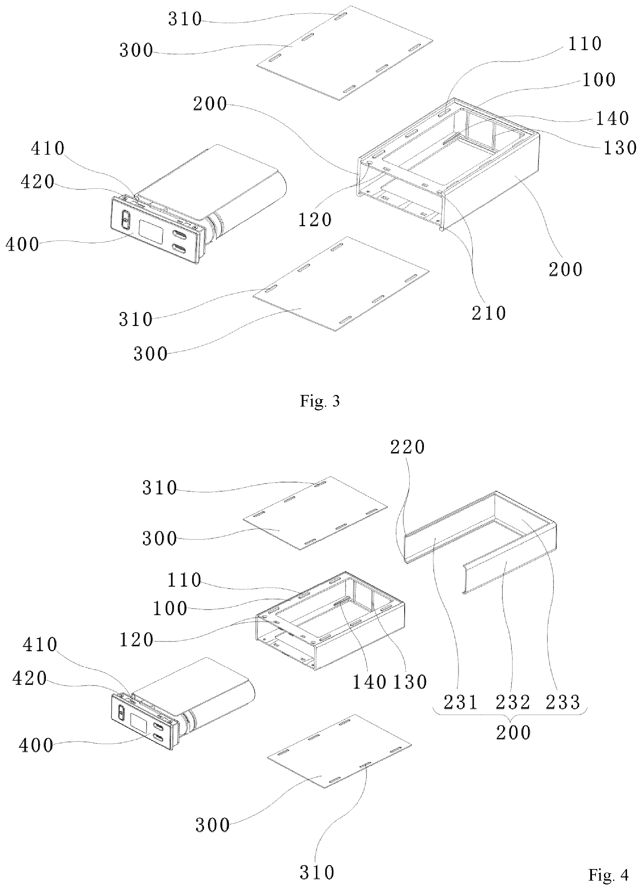

In the first embodiment of the present application as shown in Fig. 3, the torsion-resistant assembly 200 is fixedly arranged on the housing 100. The torsion-resistant assembly 200 is actually extensions protruding from the side edges of the housing 100 toward the bottom surfaces. The side edges of the torsion-resistant assembly 200 is bent toward the cover panels 300, forming a first mounting groove 210 with the bottom surfaces of the housing 100. The width of the first mounting groove 210 is arranged to match the thickness of the cover panels 300. During actual mounting, the edges of the cover panels 300 are engaged within the first mounting groove 210, thereby locking a horizontal displacement of the cover panels 300 through the plurality of torsion-resistant protrusions 110 and securing a vertical displacement of the cover panels 300 via the torsion-resistant assembly 200 located on both sides of the housing 100. This achieves a stable assembly of the cover panels 300.

In the present embodiment, an advantage of the configuration lies in minimizing the weight of the housing 100, thereby enhancing portability of the produced power bank.

In the second embodiment of the present application as shown in Fig. 4, the torsion-resistant assembly 200 is removably arranged on the housing 100. The torsion-resistant assembly 200 and the housing 100 are separate components. The torsion-resistant assembly 200 includes a first clip plate 231 and a second clip plate 232 arranged at a predetermined distance apart, and a connecting plate 233 fixedly connected to one end of the first clip plate 231 and one end of the second clip plate 232. A shape of the connecting plate 233 matches a shape of the end of the housing 100, the first clip plate 231 and the second clip plate 232 are respectively matched to the shape of the side edges of the housing 100. The first clip plate 231 and the second clip plate 232 can be sleeved on an outside of the housing 100 by means of insertion and removal during assembly. At the same time, side edges of both the first clip plate 231 and the second clip plate 232 are bent toward the cover panels 300 to form a second mounting groove 220. When the cover panels 300 are assembled on the bottom surfaces of the housing 100, after arranging the torsion-resistant assembly 200, the second mounting groove 220 can engaged with edges of the covering panels 300. During actual mounting, the plurality of torsion-resistant protrusions 110 lock the horizontal displacement of the cover panels 300, while through the torsion-resistant assembly 200 located on the both sides of the housing 100 lock the vertical displacement of the cover panels 300, to achieve an effect of stably assembling the cover panels 300.

In the present embodiment, an advantage of the configuration lies in being more convenient for mounting compared to the first embodiment, thereby enhancing production efficiency.

In the embodiments, the cover panels 300 are preferably made of carbon fiber material. The carbon fiber panel is composed of carbon fibers and resin, featuring excellent tensile and compressive low-deformation characteristics. The carbon fiber panel has high strength in four directions on plane and tends to maintain original shape, making widely used in many fields. In the embodiment, by setting the cover panels 300 as carbon fiber cover panels 300, when the housing 100 deforms under torsional forces, the plurality of torsion-resistant protrusions 110 exert tension on the cover panels 300. Due to the excellent tensile low-deformation characteristics of the cover panels 300, these can effectively resist the stretching force, thereby maintaining a relatively stable shape. This allows the overall structure of the power bank to withstand greater twisting. Besides, carbon fiber material ensures strength while having a relatively light weight, effectively reducing the overall weight and thickness of the power bank, contributing to the lightweight design of the power bank.

In an embodiment of the present application as shown in Fig. 2, a plurality of positioning holes 310 are provided through the cover panels 300. Correspondingly, a height dimension of the plurality of torsion-resistant protrusions 110 arranged on the housing 100 match a thickness dimension of the cover panels 300. During mounting, the positions of the plurality of positioning holes 310 correspond to the plurality of torsion-resistant protrusions 110, with the plurality of torsion-resistant protrusions 110 penetrating and being embedded in the positioning holes 310. The configuration enhances the combination degree between the cover panels 300 and the torsion-resistant protrusions 110, thereby achieving a more stable pulling effect.

In another implementable approach of the present application, as shown in Fig. 3, at a center of the bottom surface of the housing 100 is hollowed out to further reduce the overall weight of the housing 100. During mounting, the hollow section allows assembly personnel to observe whether the functional structures inside the housing 100 are accurately mounted in the predetermined positions. Additionally, the hollow section can serve as a mounting location for shock-absorbing and protective patches. In the embodiment, the plurality of torsion-resistant protrusions 110 are arranged along the edges of the bottom surface. As shown in Fig. 3, six torsion-resistant protrusions 110 are symmetrically placed along a longitudinal axis on each of the two bottom surfaces of the housing 100, totaling twelve torsion-resistant protrusions 110 on both top and bottom surfaces. When mounting the cover panels 300, adhesive can be applied to the side facing the housing 100 to further prevent the cover panels 300 from detaching under force.

In another implementable approach of the present application, as shown in Fig. 3, one end of the housing 100 is fitted and interlocked with the sealing member 400, while another end is closed to enhance the structural stability of the housing 100. When the sealing member 400 is fitted and interlocked with the housing 100, the sealing member 400 provides internal support to the end of the housing 100 and prevents deformation due to applied forces. In an embodiment, the plurality of mounting holes 120 are arranged on the housing 100 corresponding to the end fitted with the sealing member 400. The mounting holes 120 are hollowed out, and the sealing member 400 is arranged with elastic snap fasteners 410 that match the mounting holes 120. The elastic snap fasteners 410 can interlock with the mounting holes 120 to achieve a secure fit, ensuring a fixed combination while also facilitating subsequent maintenance. In another specific embodiment, screws 420 correspond to the mounting holes 120 can be arranged on the sealing member 400. After the sealing member 400 is fitted over the housing 100, mounting the screws 420 ensures a secure and robust attachment between the sealing member 400 and the housing 100. In other specific embodiments, the mounting holes 120 can be of various types, allowing for both an interlock with the elastic snap fasteners 410 and further fixation using the screws 420, thereby enhancing the anti-deformation performance of the housing 100.

In another implementable approach of the present application, as shown in Fig. 3, a plurality of connecting ribs 130 are also arranged inside the housing 100. The connecting ribs 130 are plate-like components with each end fixedly connected to the two bottom surfaces, thereby forming a distance constraint between the two bottom surfaces of the housing 100, and reinforcing the configuration in a thickness direction of the housing 100, thereby further enhancing the structural stability of the housing 100.

In addition, as shown in Fig. 3, a plurality of the guide ribs 140 are also arranged inside the housing 100. Since the one end of the housing 100 is closed, it is difficult for skilled personnel to observe the positioning of the functional components when mounting from the open end of the housing 100. Therefore, by arranging the guide ribs 140 inside the housing 100, the functional components can be guided to the predetermined area. One end of the guide ribs 140 is inclined, with the inclined surface facing an opening direction of the housing 100, the inclined surface of the guide ribs 140 can achieve the guiding function for the functional components.

Based on the embodiments, the actual mounting process for the torsion-resistant power bank enclosure of the present application is as follows:

As shown in Fig. 3, the sealing member 400 is arranged at an open end of the housing 100 and secured through either the elastic snap fasteners 410 or screws 420.

As shown in Fig. 1, the cover panels 300 are mounted on the two bottom surfaces of the housing 100, and the positioning holes 310 on the cover panels 300 are combined with the corresponding the torsion-resistant protrusions 110. The side edges of the cover panels 300 are engaged with the torsion-resistant assembly 200 on the both sides of the housing 100, thus completing the assembly.

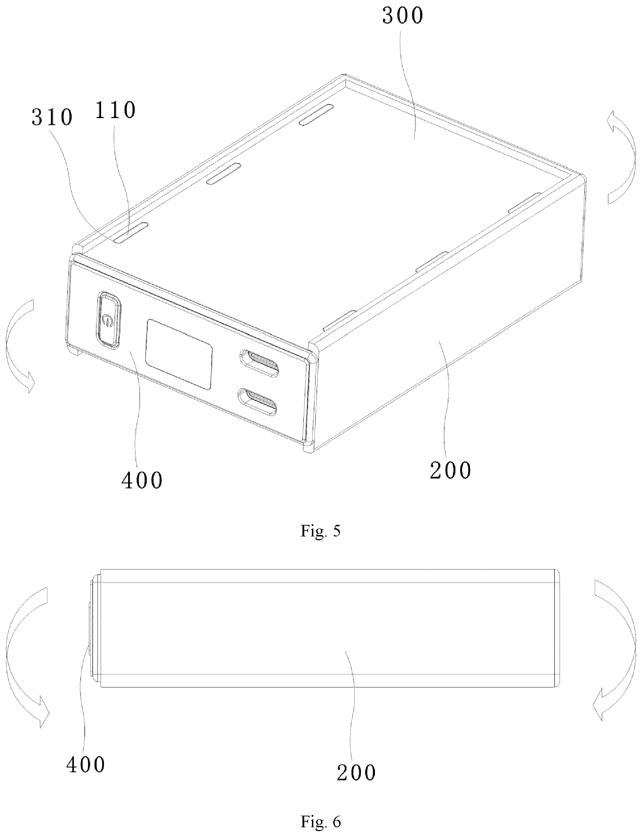

In actual use, the power bank may be subjected to external torsional forces in directions shown in Fig. 5 and Fig. 6. In both scenarios, the housing 100 tends to deform, causing the plurality of torsion-resistant protrusions 110 to displace. Due to the mounting of carbon fiber cover panels 300, the positioning holes 310 on the cover panels 300 can exert a repositioning pull on the plurality of torsion-resistant protrusions 110. Thereby, the low-deformation characteristic of the cover panel 300 resists the twisting forces acting on the housing 100, reducing the extent of deformation and enhancing the torsional resistance performance of the housing 100. This solves the problems where power bank housings in the prior art are prone to deformation under external twisting forces, which can lead to damage of internal components, improving the torsional resistance performance of the power bank housing, significantly enhancing the structural integrity and protection of the device.

Based on the embodiments, the present application also provides a mobile power bank including the torsion-resistant power bank enclosure described in the above embodiments. The torsion-resistant power bank enclosure includes: a housing, a plurality of torsion-resistant protrusions are respectively arranged on opposing bottom surfaces of the housing, and torsion-resistant assembly is respectively arranged on opposing side surfaces of the housing corresponding to the edges of the bottom surfaces; cover panels, two cover panels are respectively embedded and fitted onto the two bottom surfaces and are interlocked with the torsion-resistant protrusions, and the torsion-resistant assembly is arranged to engage with the corresponding edges of the cover panels; a sealing member, the sealing member is arranged to fit over and interlock with one end of the housing. The present application achieves the function by providing a plurality of torsion-resistant protrusions that interlock with cover panels and by arranging a torsion-resistant assembly on the housing to interlock with the cover panels. When the power bank enclosure is subjected to torsional forces, during the deformation process of the housing, the cover panels pull on the plurality of torsion-resistant protrusions to limit the extent of deformation. Simultaneously, the torsion-resistant assembly restricts the position of the cover panels to further reduce deformation. The configuration prevents damage to internal components due to excessive deformation of the housing and minimizes safety risks that may arise from accidental situations during the use of the power bank.

In summary, the present application provides a torsion-resistant power bank enclosure and a mobile power bank. The torsion-resistant power bank enclosure includes: a housing, in which a plurality of torsion-resistant protrusions are respectively arranged on opposing bottom surfaces of the housing, and torsion-resistant assembly is respectively arranged on opposing side surfaces of the housing corresponding to edges of the bottom surfaces; cover panels, two cover panels are respectively embedded and fitted onto the two bottom surfaces and are interlocked with the torsion-resistant protrusions, and the torsion-resistant assembly is arranged to engage with corresponding edges of the cover panels; a sealing member is arranged to fit over and interlock with one end of the housing. The present application arranges a plurality of anti-torsion protrusions which engage with the cover panels and arranges anti-torsion components on the housing which engage with the cover panels. When the power bank enclosure is subjected to torsional force, during the deformation process of the housing, the cover panels pull on the anti-torsion protrusions to limit the degree of housing deformation. At the same time, the anti-torsion components restrict the position further reduce deformation. The configuration prevents damage to internal components due to excessive deformation of the housing and minimizes safety risks that may arise from accidental situations during the use of the power bank.

It should be understood that the embodiments of the present application are not limited to the examples described above. For ordinary skilled persons in the art, various improvements or modifications can be made based on the descriptions, and all such improvements and modifications should fall within the protection scope of the claims attached to the present application.

## Claims

1. A torsion-resistant power bank enclosure, comprising:
a housing, wherein a plurality of torsion-resistant protrusions are respectively arranged on opposing bottom surfaces of the housing, and a torsion-resistant assembly is respectively arranged on opposing side surfaces of the housing corresponding to edges of the bottom surfaces;
cover panels, wherein two cover panels are respectively embedded and fitted onto the two bottom surfaces and interlocked with the torsion-resistant protrusions, and the torsion-resistant assembly is arranged to engage with corresponding edges of the cover panels;
a sealing member, wherein the sealing member is arranged to fit over and interlock with one end of the housing.

2. The torsion-resistant power bank enclosure according to claim **1,** wherein the torsion-resistant assembly is fixedly arranged on the housing;
the torsion-resistant assembly extends toward the bottom surfaces, and side edges of the torsion-resistant assembly is bent toward the cover panels to form a first mounting groove, wherein the edges of the cover panels are engaged within the first mounting groove.

3. The torsion-resistant power bank enclosure according to claim **1,** wherein the torsion-resistant assembly is removably arranged on the housing;
the torsion-resistant assembly comprises a first clip plate and a second clip plate arranged at a predetermined distance apart from each other, and a connecting plate fixedly connected to one end of both the first clip plate and the second clip plate, wherein side edges of both the first clip plate and the second clip plate are bent toward the cover panels to form a second mounting groove, and the edges of the cover panels and the housing are engaged within the second mounting groove.

4. The torsion-resistant power bank enclosure according to claim **1,** wherein another end of the housing is closed;
a plurality of mounting holes are arranged at the one end of the housing corresponding to the sealing member;
the sealing member is arranged with elastic snap fasteners compatible with the mounting holes; and/or the sealing member is arranged with screws compatible with the mounting holes.

5. The torsion-resistant power bank enclosure according to claim **1,** wherein a plurality of positioning holes are arranged through the cover panels, positions of the plurality of positioning holes are corresponding to positions of the plurality of torsion-resistant protrusions, and the torsion-resistant protrusions are set through and fitted into the positioning holes.

6. The torsion-resistant power bank enclosure according to claim 5, wherein the bottom surfaces of the housing are hollowed out at a center, and the torsion-resistant protrusions are uniformly arranged along the edges of the bottom surfaces.

7. The torsion-resistant power bank enclosure according to claim **1,** wherein the cover panels are carbon fiber cover panels.

8. The torsion-resistant power bank enclosure according to claim **1,** wherein a plurality of connecting ribs are arranged inside the housing, and two ends of each the connecting rib are respectively fixedly connected to the two bottom surfaces.

9. The torsion-resistant power bank enclosure according to claim **1,** wherein a plurality of guiding ribs are arranged inside the housing, one end of each the guiding rib is inclined, and the plurality of guiding ribs are arranged to position and mount functional components inside the housing.

10. A mobile power bank, wherein the mobile power bank comprises the torsion-resistant power bank enclosure according to any one of claims 1 to 9.
